**Europäisches Patentamt**

**European Patent Office**

**Office européen des brevets**

(11) Publication number: **0 126 606**

**B1**

# EUROPEAN PATENT SPECIFICATION

(45) Date of publication of patent specification: **11.07.90**

(21) Application number: **84303258.2**

(22) Date of filing: **14.05.84**

(51) Int. Cl.⁵: **H 05 K 7/20, H 01 L 23/40**

(54) Heat sink assemblies and electrical insulators used therein.

(30) Priority: **16.05.83 US 495324**

(43) Date of publication of application:
**28.11.84 Bulletin 84/48**

(45) Publication of the grant of the patent:
**11.07.90 Bulletin 90/28**

(84) Designated Contracting States:
**DE FR GB**

(56) References cited:
**DE-A-2 749 896**
**DE-A-3 028 722**
**GB-A-2 105 516**
**GB-A-2 129 629**

(73) Proprietor: **ILLINOIS TOOL WORKS INC.**
**8501 West Higgins Road**
**Chicago Illinois 60631 (US)**

(72) Inventor: **Rodseth, William G.**
**333 Joslyn**
**Elgin Illinois 60120 (US)**
Inventor: **Peterson, Francis C.**
**1426 Seventh Court**
**St. Charles Illinois 60174 (US)**

(74) Representative: **Gordon, Michael Vincent et al**
**GILL JENNINGS & EVERY 53-64 Chancery Lane**
**London WC2A 1HN (GB)**

Courier Press, Leamington Spa, England.

## Description

This invention relates to heat sink assemblies attached by fastening assemblies to printed circuit boards.

It is known to attach a heat generating electronic component, such as a power transistor, to both a heat sink and a printed circuit board by means of an electrically conductive fastener including, inter alia, a thread engageable element which is secured in an aperture in the printed circuit board, and is electrically connected to circuitry on the printed circuit board. Our US patent application 434 816 (GB 2 129 629 A) discloses arrangements which can ensure good thermal conductivity between the component and the heat sink. In some circuit designs, however, it would be desirable to attach a plurality of the components to a single heat sink. The problem is that, because the heat sink is likely to be electrically conductive, the heat sink could allow current to flow directly between the components. It would therefore be desirable to isolate the fasteners in such a way as to promote thermal conductivity, while at the same time prevent electrical conductivity, between the heat generating electronic components and the heat sink.

In accordance with one aspect of the present invention as defined in claim 1, a heat sink assembly comprises a plurality of heat generating electronic components each having electrically conductive supports requiring electrical isolation from one another, a thermally and electrically conductive heat sink for dissipating heat generated by said plurality of components, and a plurality of electrically conductive fasteners attaching said plurality of components to said heat sink and making electrical connection of said supports to a circuit, whereby a current flow directly among said supports is prevented by an electrical insulator for each of said fasteners being pre-assembled therewith, and by an insulating layer between said supports and said heat sink.

Another aspect of the present invention relates to a fastening assembly as defined in claim 7, whose pre-characterising portion is based on DE-A-3028722.

Preferably, either the fastener or the insulator has an integral spring washer to maintain clamp load and thermal conductivity between the components and the heat sink. The insulator may be formed of plastics material, such as a fibre reinforced polyphenylene sulphide material, or may be metallic with an electrically non-conductive exterior coating, such as hard-anodised aluminium. The insulator may be pre-assembled with the fastener by the provision of resilient arms on the insulator or by the plastic deformation of a portion of the fastener. Preferably, the insulator has a boss which extends into an aperture in the heat sink.

Various embodiments of the present invention will now be described, by way of example only, with reference to the accompanying drawings, in which:

Figure 1 is a bottom view of a first insulator;

Figure 2 is a sectional view of the insulator shown in Figure 1 taken along line II—II therein;

Figure 3 is a bottom view of a second insulator;

Figure 4 is a sectional view of the insulator shown in Figure 3 taken along line IV—IV therein;

Figure 5 is a plan view of a partially formed third insulator;

Figure 6 is an elevational view in partial section of the insulator shown in Figure 5 when forming part of a fastener and a heat sink assembly in accordance with the present invention;

Figure 7 is a sectional view of a fastener in accordance with the present invention;

Figure 8 is an elevational view in partial section of the insulator shown in Figures 1 and 2 when forming part of a fastener and a heat sink assembly in accordance with the present invention; and

Figure 9 is a simplified but extended view of Figure 8.

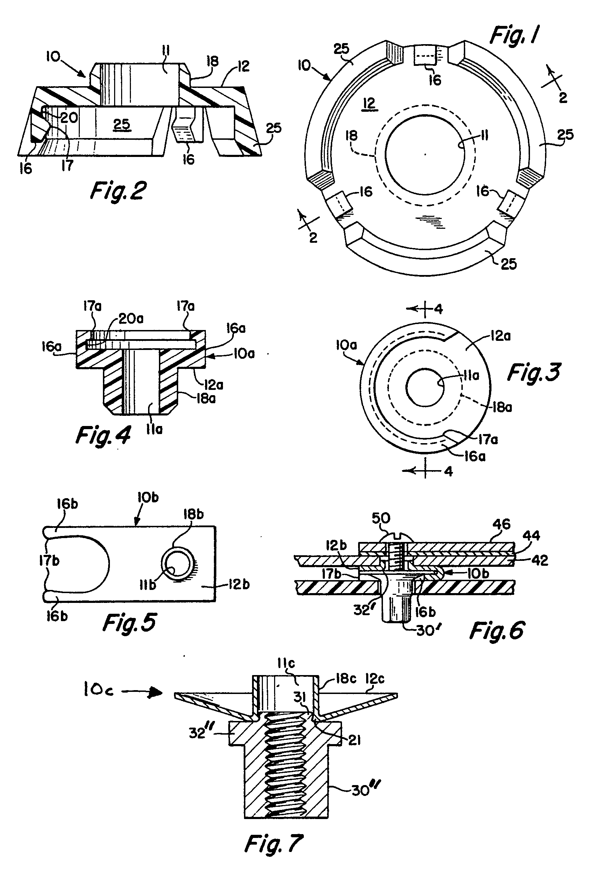

Figures 1 and 2 show an insulator 10 having a laterally extending base or washer portion 12 and an axially projecting boss or bushing 18. Depending from the base 12 are three flexible and preferably resilient arms 16. Radially inwardly projecting portions 17 on the arms 16 create recesses 20 adapted to receive a flange on a fastener in an interfering engagement. The base 12 also carries three spacing legs 25 which are longer than the arms 16, and extend generally axially from the base 12 as well as preferably extending radially outwardly to some extent. The boss 18 has an aperture 11 which extends through the base 12 and is adapted to receive an elongate portion of a fastener, such as a screw shank.

Figures 3 and 4 are views of a second insulator 10a in accordance with the present invention. In this embodiment the arm 16a is substantially continuous over a major portion of the perimeter of the base 12a. The arm 16a has an inwardly projecting portion 17a which defines a recess 20a for receiving a flanged fastener. In this embodiment the flange of the fastener is brought into engagement with the arm 16a from a direction generally perpendicular to the axis of the boss 18a and the aperture 11a. This differs from the embodiment of Figures 1 and 2 wherein a fastener is engaged with the arms 16 from a generally axial direction. In both of the above embodiments, the under surface of the base 12 and 12a is interrupted to preclude the creation of hydrostatic forces in a wave soldering operation.

The embodiments of Figures 1 to 4 show insulators formed of plastics materials. In these embodiments a high performance plastics material is preferred because significant thermal cycling can be expected. A fibre reinforced polyphenylene sulphide material, such a Ryton (R.T.M.) PPS resin, has been found to be an excellent material.

Figures 5 and 6 show a third insulator 10b in accordance with the present invention. In this embodiment, the insulator is metallic and has a surface layer of an electrically non-conductive material. The layer is preferably a hard anodized oxide formed on an aluminium base. However, any base material could be used with an exterior coating such as porcelain or the like. Figure 5 shows the third embodiment in a partially formed state. In Figure 6 the arms 16b are shown folded under the base 12b to form the pre-assemblable insulator 10b. The arms 16b have projections 17b adapted to engage a flanged fastener, in the manner to be described hereinafter. As in the second embodiment shown in Figures 3 and 4, the arms 16b form a substantially U-shape which lies generally parallel to the base 12b. The boss 18b projects in a generally axial direction from a side of the base 12b which is opposite the side from which the arms 16b are to be folded.

Figure 6 shows the insulator 10b when forming part of a fastener in accordance with the present invention which itself forms part of a heat sink assembly in accordance with the present invention. The fastener includes a thread engagable electrically conductive fastening element 30' having a generally elongate body portion for insertion into an apertured circuit board 40, with an elongate threaded fastening element 50 extending through an electronic support 46, a layer of mica 44 and a heat sink 42 to engage with said fastening element 30'. A flange 32' on the fastening element 30' is in the form of a spring washer 32' which is resiliently deformable to maintain a clamp load between the fastening element 30' and the heat sink 42.

Figure 7 shows a fourth insulator 10c when pre-assembled with a fastener 30''. Here the stamped metal insulator 10c has a boss 18c with aperture 11c and an integral spring washer as its base 12c has an electrically non-conductive coating as discussed above. The fastener 30'', which has a flange 32'', also has a collar 31 which is plastically deformed into engagement with an inwardly projecting rim 21 on the interior of the insulator 10c.

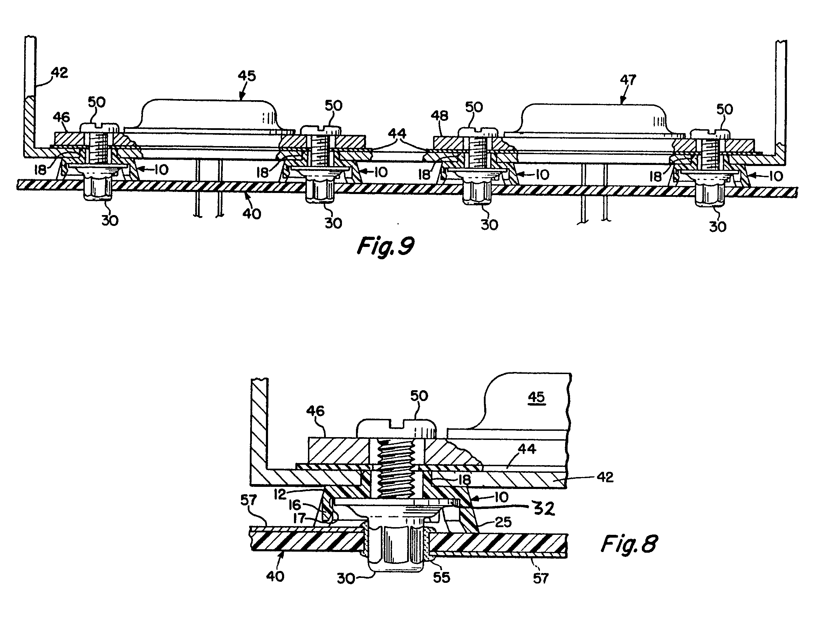

Figure 8 shows a typical heat sink assembly in which the present invention is advantageous. A first transistor 45 is mounted onto a heat sink 42 with a thin mica film 44 electrically separating them. An electrically conductive fastener comprising a screw 50 and a nut 30 are used to carry current from the transistor support 46 (collector) to the printed circuit board 40, where a solder connection 55 is made to circuitry 57. The nut 30 has an integral flange 32 which snaps into engagement with the arms 16 of the insulator 10 and provides clamp load between the transistor 45 and the heat sink 42 to maintain thermal conductivity therebetween. The boss 18, projecting from the base 12 of the insulator 10, fits into an aperture in the heat sink 42 in order to prevent arcing between the screw 50 and the heat sink 42. The problem of arcing exists when there is electrical potential between the screw and the heat sink. The legs 25 provide enhanced stability to the flanged fastener when attached to the heat sink 42 and placed on the printed circuit board 40. The legs 25 also act as spacing means to facilitate dissipation of heat by the heat sink by allowing air flow around the heat sink. The spacing means or legs 25 are intermittently placed about the periphery of the base 12 to allow venting of fluids and to promote electrical connection in a wave soldering operation.

Isolation of the heat sink 42 is also important, albeit not exclusively, when a circuit includes an assembly as shown in Figure 9 where the supports 46 and 48 of the transistors 45 and 47, respectively, are terminals (collectors) requiring connection to the circuitry of the printed circuit board 40.

## Claims

1. A heat sink assembly comprising a plurality of heat generating electronic components (45, 47) each having electrically conductive supports (46, 48) requiring electrical isolation from one another, a thermally and electrically conductive heat sink (42) for dissipating heat generated by said plurality of components, and a plurality of electrically conductive fasteners (30—30'',50) attaching said plurality of components to said heat sink and making electrical connection of said supports to a circuit (57), whereby a current flow directly among said supports (46, 48) is prevented by an electrical insulator (10—10c) for each of said fasteners being pre-assembled therewith, and by an insulating layer (44) between said supports (46, 48) and said heat sink (42).

2. A heat sink assembly according to claim 1, characterised in that each of said fasteners or said insulators has an integral spring washer for maintaining clamp load and thermal conductivity between said components and said heat sink.

3. A heat sink assembly according to claim 1 or claim 2, characterised in that each of said insulators (10, 10a) is formed of a fibre reinforced polyphenylene sulphide material.

4. A heat sink assembly according to claim 1 or claim 2, characterised in that each of said insulators (10b, 10c) is metallic and has an electrically non-conductive exterior coating.

5. A heat sink assembly according to claim 4, characterised in that each of said insulators (10c) is attached to its fastener by plastic deformation of a portion of said fastener.

6. A heat sink assembly according to any one of claims 1 to 4, characterised in that each of said insulators (10—10b) is attached to its fastener by one or more resilient arms (16—16b) on said insulator.

7. A fastening assembly, for use in attaching heat generating electronic components (45, 47) to and electrically isolating said components from an electrically conductive heat dissipating member (42), comprising a threaded electrically conductive fastening element (30—30'') having a generally elongate body portion insertible into an apertured circuit board (40) and an electrical insulator (10—10c) to help prevent current flow from said fastening element (30—30'') to said member (42), characterised in that said fastening element (30—30'') is internally threaded, said body of said fastening element is formed as a nut having an integral flange (32—32'') at one end thereof, and said electrical insulator (10—10c) is connected to said fastening element adjacent to said flange by attaching means (16—16b, 21).

8. A fastening assembly according to claim 7, characterised in that said flange (32, 32') is a spring washer resiliently deformable such that clamp load is maintainable between said fastening element (30, 30') and said member (42).

9. A fastening assembly, according to claim 7 or claim 8, characterised in that said attaching means includes at least one flexible arm (16—16b) integral with said electrical insulator (10—10b), said electrical insulator includes a generally planar base (12—12b) and a boss (18—18b) projecting therefrom, and said at least one arm (16—16b) is resiliently deflectable into engagement with said fastening element.

10. A fastening assembly according to claim 9, characterised in that said at least one arm has a generally radially inwardly directed protrusion (17—17b) for engaging said fastening element in an interference fit.

11. A fastening assembly according to claim 7, characterised in that said attaching means includes a plastically deformable collar (31) on said fastening element (30'') staked into interfering engagement with a portion (21) of said electrical insulator (10c) which is metallic and has an electrically non-conductive exterior coating.

12. A fastening assembly according to any one of claims 7 to 11 when forming part of a heat sink assembly according to any one of claims 1 to 6.

**Patentansprüche**

1. Wärmesenkenanordnung, gekennzeichnet durch eine Vielzahl von Wärme erzeugenden elektronischen Komponenten (45, 47), die jeweils elektrisch leitende Stützen (46, 48) aufweisen, die eine elektrische Isolierung voneinander erfordern, eine thermisch und elektrisch leitende Wärmesenke (42) zur Verteilung der Wärme, die durch die Vielzahl von Komponenten erzeugt wird, und eine Vielzahl von elektrisch leitenden Befestigern (30—30'', 50), die die Vielzahl von Komponenten an der Wärmesenke befestigen und eine elektrische Verbindung der Stützen zu einem Schaltkreis (57) herstellen, wodurch ein Stromfluß direkt zwischen den Stützen (46, 48) durch einen elektrischen Isolator (10—10c) für jeden der Befestiger, der damit vormontiert wird, und durch eine Isolierschicht (44) zwischen den Stützen (46, 48) und der Wärmesenke (42) verhindert wird.

2. Wärmesenkenanordnung nach Anspruch 1, dadurch gekennzeichnet, daß jeder der Befestiger oder der Isolatoren eine integrierte Federunterlegscheibe zum Aufrechterhalten einer Klammerlast und thermischen Leitfähigkeit zwischen den Komponenten und der Wärmesenke aufweist.

3. Wärmesenkenanordnung nach Anspruch 1 oder 2, dadurch gekennzeichnet, daß jeder der Isolatoren (10, 10a) durch einen faserverstärkten Polyphenylensulfid-Werkstoff gebildet ist.

4. Wärmesenkenanordnung nach Anspruch 1 oder 2, dadurch gekennzeichnet, daß jeder der Isolatoren (10b, 10c) metallisch ist und eine elektrisch nicht leitende äußere Beschichtung aufweist.

5. Wärmesenkenanordnung nach Anspruch 4, dadurch gekennzeichnet, daß jeder der Isolatoren (10c) an seinem Befestiger durch plastische Verformung eines Abschnitts des Befestigers befestigt ist.

6. Wärmesenkenanordnung nach einem der Ansprüche 1 bis 4, dadurch gekennzeichnet, daß jeder der Isolatoren (10—10b) an seinem Befestiger durch einen oder mehrere nachgiebige Arme (16—16b) auf dem Isolator befestigt ist.

7. Befestigeranordnung für die Befestigung Wärme erzeugender elektronischer Komponenten (45, 47) an und zum elektrischen Isolieren der Komponenten gegenüber einem elektrisch leitenden Wärmeverteilkörper (42) mit einem mit Gewinde versehenen elektrisch leitenden Befestigungselement (30—30''), welches einen allgemein langgestreckten Körperabschnitt aufweist, der in ein mit Löchern versehenes Schaltkreisplatte (40) einsetzbar ist, und einem elektrischen Isolator (10—10c), der dazu beiträgt, Stromfluß von dem Befestigungselement (30—30'') zu dem Körper (42) zu verhindern, dadurch gekennzeichnet, daß das Befestigungselement (30—30'') innen mit Gewinde versehen ist, daß der Körper des Befestigungselements als eine Mutter ausgebildet ist, die einen integrierten Flansch (32—32'') an ihrem einen Ende aufweist, und der elektrische Isolator (10—10c) an dem Befestigungselement nahe am Flansches durch Befestigungsmittel (16—16b, 21) verbunden ist.

8. Befestigungsanordnung nach Anspruch 7, dadurch gekennzeichnet, daß der Flansch (32, 32') eine Federunterlegscheibe ist, die nachgiebig verformbar ist, so daß eine Federlast zwischen dem Befestigungselement (30, 30') und dem Körper (42) aufrechterhalten wird.

9. Befestigungsanordnung nach Anspruch 7 oder 8, dadurch gekennzeichnet, daß das Befestigungsmittel zumindest einen elastischen Arm (16—16b) aufweist, der mit dem elektrischen Isolator (10—10b) integriert ist, daß der elektrische Isolator eine allgemein ebene Basis (12—12b) aufweist und einen daraus aufragenden runden Vorsprung (18—18b), und daß zumindest ein Arm (16—16b) nachgiebig abbiegbar in Eingriff mit dem Befestigungselement bringbar ist.

10. Befestigungsanordnung nach Anspruch 9, dadurch gekennzeichnet, daß der zumindest eine Arm einen allgemein radial nach innen gerichteten Vorsprung (17—17b) zum Eingriff mit dem Befestigungselement in einem Festsitz aufweist.

11. Befestigungsanordnung nach Anspruch 7, dadurch gekennzeichnet, daß das Befestigungsmittel einen plastisch verformbaren Kragen (31) auf dem Befestigungselement (30'') aufweist, der in fester Verbindung mit einem Abschnitt (21) des elektrischen Isolators (10c) gesteckt wird, welcher metallisch ist und eine elektrisch nicht leitende äußere Beschichtung aufweist.

12. Befestigungsanordnung nach einem der Ansprüche 7 bis 11, dadurch gekennzeichnet, daß sie einen Teil der Wärmesenkenanordnung nach einem der Ansprüche 1 bis 6 bildet.

**Revendications**

1. Assemblage de radiateur comprenant plusieurs composants électroniques (45, 47) générant de la chaleur, ayant chacun des supports électriquement conducteurs (46, 48) qui doivent être isolés électriquement les uns des autres, un radiateur (42) thermiquement et électriquement conducteur, destiné à dissiper la chaleur générée par lesdits plusieurs composants, et plusieurs organes de fixation (30—30'', 50) électriquement conducteurs, reliant lesdits plusieurs composants audit radiateur et établissant une connexion électrique desdits supports sur un circuit (57), une circulation directe du courant entre lesdits supports (46, 48) étant empêchée par un isolateur électrique (10—10c) pour chacun desdits organes de fixation avec lequel il est préalablement assemblé, et par une couche isolante (44) entre lesdits supports (46, 48) et ledit radiateur (42).

2. Assemblage de radiateur selon la revendication 1, caractérisé en ce que chacun desdits organes de fixation ou desdits isolateurs est réalisé d'une seule pièce avec une rondelle à ressort destinée à maintenir une charge de bridage et la conductibilité thermique entre lesdits composants et ledit radiateur.

3. Assemblage de radiateur selon la revendication 1 ou la revendication 2, caractérisé en ce que chacun desdits isolateurs (10, 10a) est formé d'une matière du type sulfure de polyphénylène armé de fibre.

4. Assemblage de radiateur selon la revendication 1 ou la revendication 2, caractérisé en ce que chacun desdits isolateurs (10b, 10c) est métallique et comporte un revêtement extérieur électriquement non conducteur.

5. Assemblage de radiateur selon la revendication 4, caractérisé en ce que chacun desdits isolateurs (10c) est relié à son organe de fixation par une déformation plastique d'une partie dudit organe de fixation.

6. Assemblage de radiateur selon l'une quelconque des revendications 1 à 4, caractérisé en ce que chacun desdits isolateurs (10—10b) est relié à son organe de fixation par un ou plusieurs bras élastiques (16—16b) sur ledit isolateur.

7. Ensemble de fixation, à utiliser pour relier des composants électroniques (45, 47) générant de la chaleur à un organe électriquement conducteur (42) dissipant la chaleur, et pour isoler électriquement lesdits composants de cet organe, comprenant un élément fileté (30—30'') de fixation, électriquement conducteur, ayant une partie du corps globalement allongée pouvant être insérée dans une plaquette à circuit perforée (40) et un isolateur électrique (10—10c) destiné à aider à empêcher la circulation du courant dudit élément de fixation (30—30'') vers ledit organe (42), caractérisé en ce que ledit élément de fixation (30—30'') est fileté intérieurement, ledit corps dudit élément de fixation est réalisé sous la forme d'un écrou formé d'une seule pièce avec un rebord (32—32'') à une extrémité, et ledit isolateur électrique (10—10c) est relié audit élément de fixation à proximité immédiate dudit rebord par des moyens de liaison (16—16b, 21).

8. Ensemble de fixation selon la revendication 7, caractérisé en ce que ledit rebord (32, 32') est une rondelle à ressort pouvant être déformée élastiquement afin qu'une charge de bridage puisse être maintenue entre ledit élément de fixation (30, 30') et ledit organe (42).

9. Ensemble de fixation selon la revendication 7 ou la revendication 8, caractérisé en ce que lesdits moyens de liaison comprennent au moins un bras flexible (16—16b) réalisé d'une seule pièce avec ledit isolateur électrique (10—10b), ledit isolateur électrique comprend une base globalement plane (12—12b) et un bossage (18—18b) qui en fait saillie, et ledit, au moins un, bras (16—16b) peut être déformé élastiquement pour s'enclencher avec ledit élément de fixation.

10. Ensemble de fixation selon la revendication 9, caractérisé en ce que ledit, au moins un, bras comporte une saillie (17—17b) dirigé globalement radialement vers l'intérieur pour s'enclencher par ajustement serré avec ledit élément de fixation.

11. Ensemble de fixation selon la revendication 7, caractérisé en ce que lesdits moyens de liaison comprennent un collet (31) pouvant être déformé plastiquement sur ledit élément (30'') de fixation emboîté en prise serrée dans une partie (21) dudit isolateur électrique (10c) qui est métallique et qui comporte un revêtement extérieur électriquement non conducteur.

12. Ensemble de fixation selon l'une quelconque des revendications 7 à 11, lorsqu'il fait partie d'un assemblage de radiateur selon l'une quelconque des revendications 1 à 6.

Fig. 1

Fig. 2

Fig. 3

Fig. 4

Fig. 5

Fig. 6

Fig. 7

Fig.9

Fig.8